Europäisches Patentamt

European Patent Office

Office européen des brevets

(11) Numéro de publication: **0 287 458**
A1

## (12) DEMANDE DE BREVET EUROPEEN

(21) Numéro de dépôt: 88400884.8

(22) Date de dépôt: 13.04.88

(51) Int. Cl.⁴: **H 01 L 31/02**
H 01 L 31/10

(30) Priorité: 14.04.87 FR 8705256

(43) Date de publication de la demande:
19.10.88  Bulletin  88/42

(84) Etats contractants désignés: DE GB IT NL SE

(71) Demandeur: SAT Société Anonyme de
Télécommunications
41, rue Cantagrel
F-75631 Paris Cedex 13  (FR)

(72) Inventeur: Royer, Michel
29, rue Claude Decaen
F-75012 Paris  (FR)

(74) Mandataire: Bloch, Gérard et al
6, rue du Faubourg Saint-Honoré
F-75008 Paris  (FR)

(54) **Photodiode HgCdTe à réponse rapide.**

(57)  La photodiode est réalisée dans un substrat (1) semiconducteur HgCdTe de type P. Sur une face de ce substrat (1) est
formée une zone dopée (2) de type N. Une métallisation (3) est
en contact avec une couche (5) de tellurure de cuivre Cu₂Te,
disposée sur l'autre face du substrat (1) semiconducteur
HgCdTe, en regard de la jonction PN.
   Une telle photodiode, sensible dans l'infra-rouge proche,
possède une résistance série faible, ce qui lui confère une
réponse rapide.

EP 0 287 458 A1

Bundesdruckerei Berlin

## Description

## Photodiode HgCdTe à réponse rapide

La présente invention a pour objet une photodiode, réalisée dans un substrat semiconducteur HgCdTe de type P, dans lequel est formée, sur une face, une zone dopée de type N réalisant ainsi une jonction PN, et pourvu de métallisations d'accès aux zones P et N.

De telles photodiodes sont sensibles dans l'infrarouge proche, et la longueur d'onde sur laquelle est centrée leur maximum de sensibilité dépend de la composition du cristal de semiconducteur du substrat. Cette composition est définie par la fraction molaire x de la formule $Hg_{1-x}Cd_xTe$, fraction molaire qui peut varier de 0 à 1. Ces photodiodes sont en particulier utilisées dans les télécommunications par fibres optiques, à des longueurs d'onde de 1,30 et 1,55 microns, par exemple.

On connaît déjà des photodiodes du type défini ci-dessus, qui présentent toutefois l'inconvénient d'avoir une réponse relativement lente, c'est-à-dire qu'elles transmettent mal les composantes élevées du spectre fréquentiel des signaux qui modulent les rayonnements lumineux qu'elles détectent. Actuellement, les fréquences de coupure de ces photodiodes sont de l'ordre de 500 à 800 MHz. Il est évident que ceci limite le débit des informations qui peuvent être transmises dans les systèmes de télécommunications par fibres optiques. Il est donc primordial de disposer des photodiodes ayant une fréquence de coupure plus élevée. Or, il est connu que la fréquence de coupure d'une photodiode est d'autant plus élevée que le produit RC, de la résistance série R et de la capacité C de son schéma équivalent, est faible. Ainsi, un moyen pour augmenter la fréquence de coupure consiste à réduire la valeur de la résistance série R du schéma équivalent.

Or, cette résistance R est la résistance série totale de la photodiode, et les deux composantes principales de cette résistance sont, d'une part, la résistance du substrat semiconducteur HgCdTe de type P, et d'autre part la résistance du contact entre ce substrat et la métallisation qui permet d'y accéder.

Pour diminuer la résistance du substrat, on peut, par polissage mécanique, en réduire l'épaisseur, par exemple jusqu'à 50 µm, qui représente sensiblement la limite inférieure de ce qu'il est possible de faire. On obtient alors, par exemple dans le cas d'un disque de HgCdTe de type P, de résistivité de 10Ω cm et de diamètre 150 µm, une résistance du substrat de l'ordre de 200 Ω.

A cette valeur, il est cependant nécessaire d'ajouter la valeur de la résistance de contact avec la métallisation, pour obtenir la résistance série totale R de la photodiode. Or, il est difficile de réduire la résistance de contact avec la technique connue qui consiste à intercaler, entre le cristal semiconducteur de type P et le métal de la métallisation, une couche surdopée de type $P^+$. En effet, comme cela est connu, l'alliage HgCdTe est difficile à surdoper, et il subsiste toujours un effet de redressement entre le substrat de type P et la couche de type $P^+$, qui augmente la résistance du contact.

La présente invention vise à pallier cet inconvénient en procurant une photodiode dont la résistance de contact entre le substrat et la métallisation est faible, afin d'obtenir une résistance série totale faible, et dont une réponse rapide.

A cet effet, la présente invention a pour objet une photodiode du type défini ci-dessus, caractérisée par le fait que la métallisation d'accès à la zone P est en contact avec une couche dégénérée de $Cu_2Te$ disposée sur la face P dudit substrat semiconducteur HgCdTe en regard de la jonction PN.

Dans la photodiode de l'invention, le tellurure du cuivre $Cu_2Te$ étant un semiconducteur dégénéré de faible résistivité, il réalise, entre le substrat de type P et la métallisation, un contact de faible résistance.

Avantageusement, ladite couche dégénérée a une épaisseur de sensiblement 0,1 µm.

Avantageusement encore, ladite couche dégénérée est obtenue en immergeant ledit substrat dans une solution aqueuse de CuCl.

Dans ce cas, la couche de $Cu_2Te$ est obtenue, de façon simple, par échange ionique.

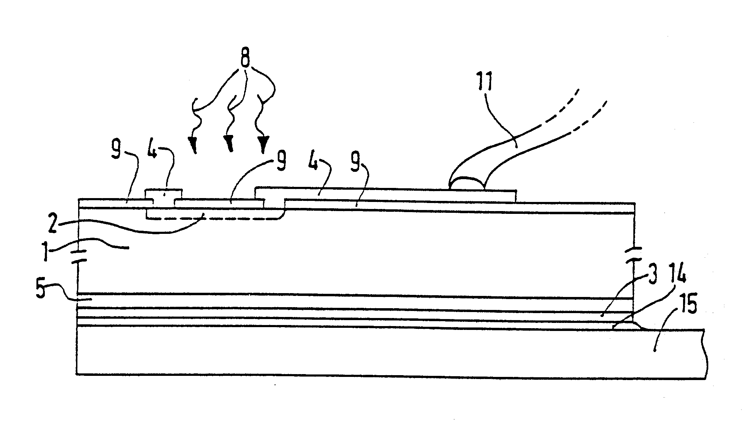

La présente invention sera mieux comprise à l'aide de la description suivante de la forme de réalisation préférée de la photodiode de l'invention, et de son procédé de réalisation, en référence au dessin annexé, sur lequel l'unique figure représente une vue schématique en coupe de la photodiode selon l'invention.

L'unique figure représente une photodiode, pour détecter un rayonnement infrarouge schématisé sous forme de photons incidents 8, et transformer ce rayonnement détecté en un signal électrique apparaissant entre deux métallisations 3 et 4.

De façon connue, la photodiode comprend une jonction PN, résultat de la formation d'une zone 2 de type N sur la face supérieure, sur la figure, d'un substrat 1 semiconducteur HgCdTe de type P. La métallisation 4, disposée également sur la face supérieure du substrat 1 permet, à travers une couche de passivation 9, l'accès à la zone 2 de type N. Un fil 11 de connexion est soudé à la métallisation 4.

Sur la face inférieure, sur la figure, du substrat 1, la métallisation 3 est en contact avec toute la surface d'une couche 5 de tellurure de cuivre $Cu_2Te$, en regard de la jonction PN. La métallisation 3 est collée, à l'aide d'une couche de colle conductrice 14, à un support 15 en alumine métallisée.

Ainsi, on peut dire que la métallisation 3 permet l'accès à la zone P, c'est-à-dire au substrat 1 de HgCdTe de type P, par l'intermédiaire de la couche de tellurure de cuivre $Cu_2Te$.

Sur la figure, les métallisations 3 et 4 sont connectées, par l'intermédiaire du support 15 et du fil 11, respectivement, à des broches du boîtier, non représenté dans un souci de simplicité, dans lequel est montée la photodiode.

La photodiode qui vient d'être décrite est réalisée comme cela va maintenant être expliqué.

On part d'un cristal massif de HgCdTe de type P, obtenu par exemple par le procédé THM (Travelling Heater Method) décrit dans le brevet français n° 2 502 190 ou par le procédé THM modifié décrit dans la demande de brevet français n° 86 00 769. Le cristal massif est ensuite aminci par polissage mécanique, pour former le substrat 1, d'épaisseur ici de l'ordre de 100 µm.

Les tranches et la face supérieure, sur la figure, du substrat 1 sont alors masquées à l'aide d'une résine de photogravure, et le substrat 1 est immergé dans une solution aqueuse de CuCl. La solution aqueuse de CuCl a ici une concentration de 4 g/l, elle est chauffée à 80°C et le substrat 1 y est immergé pendant 15 mn, ce qui permet d'obtenir une couche 5 de tellurure de cuivre $Cu_2Te$ d'épaisseur 0,1 µm environ.

Au cours de cette immersion, le tellulurure de cuivre $Cu_2Te$ est obtenu par échange ionique, un atome de cadmium étant remplacé par deux atomes de Cu pour donner le semiconducteur dégénéré $Cu_2Te$.

La réaction est améliorée par l'adjonction de chlorure, de bromure, ou d'iodure d'un métal alcalin ou alcalinoterreux, par exemple chlorure de sodium, iodure de potassium, ou sel d'ammonium, pour solubiliser le chlorure cuivreux, d'hydrazine dichlorate, un agent réducteur, pour stabiliser le degré d'oxydation de cuivre, et de tartrate de sodium pour ajuster le pH à une valeur de l'ordre de 4 à 5. Un rinçage soigneux est effectué à la fin de la réaction.

On peut alors former la zone 2 de type N, en procédant de façon connue, par exemple par la technique planar de diffusion de mercure à travers des couches de passivation, comme l'enseigne le brevet français N° 2 336 804, ou encore par implantation ionique d'indium ou d'aluminium, comme l'enseigne le brevet français N° 2 488 048. Un anneau de garde, de type connu également, peut être réalisé.

Avec une fraction molaire, ou composition, x voisine de 0,7, la photodiode réalisée à l'aide d'un cristal de $Hg_{0,3}Cd_{0,7}Te$ aura un maximum de sensibilité centré sur une longueur d'onde de 1,3 µm. En choisissant une valeur différente, on peut déplacer, de façon connue, ce maximum de sensibilité, et, en particulier en amener la valeur jusqu'à 2 µm pour x voisin de 0,2.

On peut également, et selon l'enseignement du brevet français n° l2 501 915 choisir la composition x de façon à ce que les énergies de bande interdite Eg et de bande de spin-orbite soient voisines, ce qui procure un gain en courant, par effet de multiplication.

Les principales caractéristiques des photodiodes ainsi réalisées, fonctionnant à température ambiante, avec une surface sensible circulaire de diamètre 80 µm, adaptée au diamètre des fibres optiques pour télécommunications sont les suivantes, pour x = 0,7 :

Tension de polarisation inverse : -10 V
Courant inverse (V = -10 V ) : < ;10 nA
Réponse en courant à $\lambda$ = 1,3 um : > ;0,7 A/W
Capacité totale (V = -10 V ) : 0,7 pF

Résistance série : 200 $\Omega$
Résistance inverse : 1000 M$\Omega$
Temps de montée : 300 ps
Fréquence de coupure (-3 dB) : 1000 MHz

Comme on le constate, la faible valeur de la résistance série conduit à une fréquence de coupure plus élevée que pour les photodiodes de l'art antérieur.

**Revendications**

1. Photodiode réalisée dans un substrat (1) semiconducteur HgCdTe de type P, dans lequel est formée, sur une face, une zone (2) dopée de type N réalisant ainsi une jonction PN, et pourvu de métallisations (3, 4) d'accès aux zones P et N, caractérisée par le fait que la métallisation (3) d'accès à la zone P est en contact avec une couche (5) dégénérée de $Cu_2Te$ disposée sur la face P dudit substrat (1) semiconducteur HgCdTe en regard de la jonction PN.

2. Photodiode selon la revendication 1, dans laquelle ladite couche (5) dégénérée a une épaisseur de sensiblement 0,1 µm.

3. Photodiode selon l'une des revendications 1 ou 2, pour laquelle ladite couche (5) dégénérée est obtenue en immergeant ledit substrat (1) dans une solution aqueuse de CuCl.

4. Photodiode selon la revendication 3, pour laquelle ladite solution aqueuse de CuCl ayant une concentration de sensiblement 4 g/$\ell$ et étant chauffée à sensiblement 80°C, ledit substrat (1) est immergé pendant sensiblement 15 mn dans ladite solution aqueuse.

5. Photodiode selon l'une des revendications 3 ou 4, pour laquelle ladite solution aqueuse de CuCl contient, de plus, du tartrate de sodium de façon à ce que son pH reste compris entre sensiblement 4 et sensiblement 5.

6. Photodiode selon l'une des revendications 3 à 5, pour laquelle ladite solution aqueuse de CuCl contient, de plus, un corps choisi parmi les suivants : chlorure, bromure ou iodure d'un métal alcalin ou alcalinoterreux.

7. Photodiode selon l'une des revendications 3 à 6, dans laquelle ladite solution aqueuse de CuCl contient, de plus, un agent réducteur.

8. Photodiode selon la revendication 7, dans laquelle ledit agent réducteur est de l'hydrazine dichlorate.

9. Photodiode selon l'une des revendications 1 à 8, dans laquelle la composition dudit substrat (1) semiconducteur HgCdTe étant définie par la formule $Hg_{1-x}Cd_xTe$, la fraction molaire x est comprise entre sensiblement 0,2 et sensiblement 0,7.

0287458

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | GB-A-2 103 878  (THE SECRETARY OF STATE FOR DEFENCE)<br>* Page 1, lignes 50-102; revendications; figures * | 1,9 | H 01 L  31/02<br>H 01 L  31/10 |
| A | US-A-4 439 912  (J.H. POLLARD)<br>* Colonne 2, ligne 16 - colonne 3, ligne 39; revendications; figures * | 1 | |
| A | US-A-4 357 620  (CHENG-CHI WANG et al.)<br>* Colonne 2, ligne 64 - colonne 6, ligne 37; revendications * | 1,9 | |
| A | US-E-  31 968  (R.A. MICKELSEN et al.)<br>* Colonne 9, ligne 37 - colonne 16, ligne 6; figures 2,4 * | 1 | |

**DOMAINES TECHNIQUES RECHERCHES (Int. Cl.4)**

H 01 L

Le présent rapport a été établi pour toutes les revendications

| Lieu de la recherche | Date d'achèvement de la recherche | Examinateur |
|---|---|---|
| LA HAYE | 16-06-1988 | VISENTIN A. |

EPO FORM 1503 03.82 (P0402)